# EUROPEAN PATENT APPLICATION

(11) **EP 1 895 550 A1**
(43) Date of publication of application: **05.03.2008**
(21) Application number: 06460030.7
(22) Date of filing: 30.08.2006
(51) Int. Cl.: H01F 37/00, H03H 1/00, H01F 3/10

(54) **A device for suppressing high frequency current or/and voltage components**

(71) Applicant: ABB RESEARCH LTD., 8050 Zürich (CH)
(72) Inventor: Piasecki, Wojciech, 30-009 Krakow (PL); Bywalec, Grzegorz, 32-602 Oswiecim (PL); Florkowski, Marek, 31-216 Krakow (PL)
(74) Representative: Chochorowska-Winiarska, Krystyna

(57) **Abstract**

The subject of the invention is a device for suppressing high frequency current or/and voltage components, applicable in protecting electrical equipment, especially against the effects of overvoltage in electrical power networks and stations. The inventive device is characterised in that it contains a series impedance element which is at least one magnetic core reactor whose magnetic circuit comprises at least two active parts on which the reactor windings are wound, which are connected with each other in series and anti-parallel.

## Description

The subject of the invention is a device for suppressing high frequency current or/and voltage components, applicable in protecting electrical equipment, especially against the effects of overvoltage in electrical power networks and stations.

Electrical equipment working in electrical power networks, especially transformers and motors are exposed to the effects of adverse high frequency phenomena generated as a result of switching processes or lightning surges. Examples of such adverse phenomena can be occurrences connected with multiple arc ignitions in vacuum circuit breakers or wave phenomena occurring in low-loss cables with polyethylene insulation. Use of this type of equipment becomes more and more popular, which requires more and more common use of protective equipment to reduce the steepness of the rise in voltage on the terminals of electrical equipment and/or to reduce the overvoltage value expressed by the overvoltage amplitude. Both these adverse phenomena cause rapid degradation of the insulating system of electrical equipment.

A known way of reducing overvoltage value is the use of varistor-type overvoltage limiters. However, their operation does not protect the equipment against the other adverse phenomenon, namely it does not reduce the steepness of the rise in voltage on the terminals of electrical equipment.

Known methods for protecting electrical equipment against damaging high-frequency phenomena consist in using surge capacitors C or RC snubbers, which are connected between the terminal of the protected equipment and earth. However, the use of the RC elements consists mainly in ensuring wave impedance matching of equipment and the electrical power line. The protective action reducing the steepness of the rise in voltage requires the use of large capacitance values, which results in large dimensions of protective equipment. To avoid it, a series impedance element is connected between the electrical power line and the protected piece of equipment. Such series device can be a reactor whose winding is a conductor going through the opening (centre) of a toroidal core. The series impedance element must be so selected that its impedance for the network frequency, usually 50 Hz, is near zero.

An example of such device which is a series impedance element is shown in patent description US 6 642 806. It is a magnetic element surrounding a current-carrying wire, the magnetic element being made of a material of strictly defined magnetic permeability and conductivity, such that, for the frequency range threatening the protected piece of equipment, its material properties will ensure the necessary insertion loss of the wire situated in it. The magnetic element is a toroidal core whose magnetic circuit has the form of a current-carrying wire placed within the inside diameter of the toroidal core. The presented patent description reveals a method for filtering high-frequency components of current and voltage for medium and high voltage networks. However, it is difficult to provide protection for electrical equipment within a frequency range below 100 kHz by means of this device and method and it requires the use of magnetic elements of large dimensions or high magnetic permeability, which in turn results in saturation of the magnetic material if we have to do with a low-frequency component of the work current.

Patent description US 6 385 029 describes a device for suppressing high frequencies in electrical power lines. This device contains a reactor formed by multiple toroidal cores situated in series, the element connecting these cores being a section of a current-carrying wire which is wound on consecutive cores.

The essence of the present inventive device which makes use of a series impedance element is that the series impedance element is at least one reactor with a magnetic core whose magnetic circuit comprises at least two active parts on which the reactor windings connected with each other in series and anti-parallel are wound.

Preferably the active parts are separate magnetic cores.

Preferably the magnetic cores are interconnected by a closing part, forming a magnetic core open on one end.

Preferably the magnetic cores are interconnected by closing parts, forming a closed magnetic core.

Preferably the active parts of the core together with the parts that close the magnetic circuit of the core are a toroidal core which is made of one magnetic material whose characteristic feature is that it its magnetic permeability decreases rapidly with the increase in frequency.

Preferably the closed magnetic core has the form of a circular ring. Preferably the active parts are made of magnetic material with a broad-band magnetic permeability characteristic.

Preferably the parts that close the magnetic circuit of the core are made of magnetic material for which permeability decreases rapidly with the increase in frequency.

Preferably the device consists of at least two magnetic-core reactors interconnected in series and forming a stack in which the neighbouring windings of the neighbouring reactors are situated in such way that the magnetic fluxes produced by them are directed in opposite directions.

Preferably the reactor stack is placed in a common housing.

Preferably a resistor is connected in parallel series to the input and output terminals of the reactor.

Preferably the device for suppressing high frequency current and voltage components is placed inside a high-voltage bushing.

The advantage of the inventive device is that it provides protection for electrical equipment both in respect of reducing the overvoltage value and reducing the steepness of voltage rise, while maintaining small dimensions of the device.

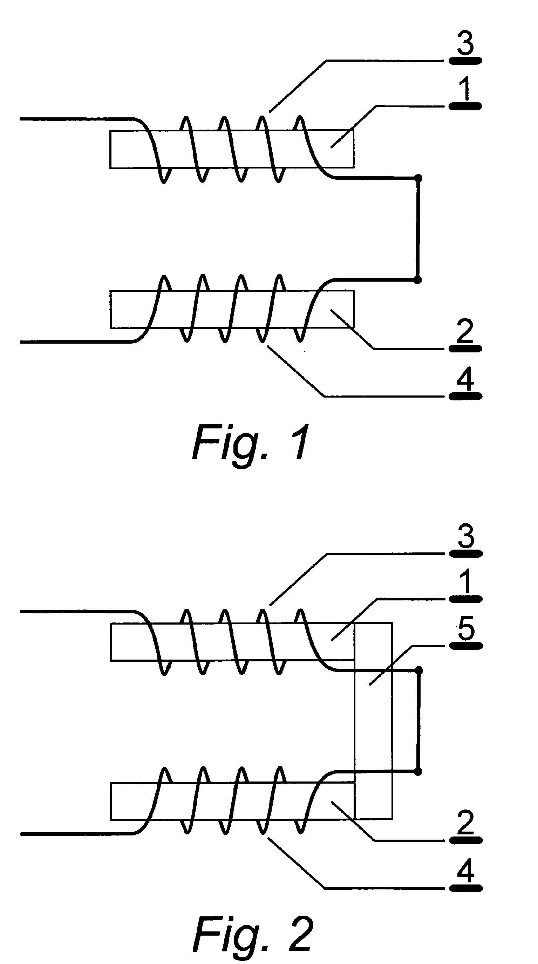

The inventive device is presented as an illustrative embodiment in the drawing where fig. 1 shows the reactor in the first embodiment of the invention, containing two separate magnetic cores, fig. 2 shows the reactor in the second embodiment of the invention, containing two magnetic cores connected on one end, fig. 3 shows the reactor in the third embodiment of the invention, containing two magnetic cores connected with each other, fig. 4 shows a variant of the reactor from fig. 4, fig. 5 shows the device containing reactors whose magnetic cores are arranged in a stack, and fig. 6 shows a schematic diagram of the inventive device with a resistor connected between the input and output terminals of the device.

Embodiment I of the invention.
The device for suppressing high frequency current and voltage components is a reactor which contains active parts in the form of two magnetic cores, the first one 1 and the second one 2. On the first magnetic core 1 there is wound winding 3, which is connected in series and anti-parallel with winding 4, which is wound on the second magnetic core 2. The magnetic cores 1 and 2 are made of magnetic material with a broad-band magnetic permeability characteristic. For example, such material can be Mn-Zn ferrite.

Embodiment II of the invention.
The device for suppressing high frequency current and voltage components is a reactor which contains active parts in the form of two magnetic cores, the first one 1 and the second one 2. On the first magnetic core 1 there is wound winding 3, which is connected in series and anti-parallel with winding 4, which is wound on the second magnetic core 2. Both magnetic cores 1 and 2 are connected with each other by means of a closing part 5 in the form of a magnetic core of different magnetic properties than those of the cores 1 and 2. The magnetic cores 1 and 2 are made of magnetic material with a broad-band magnetic permeability characteristic. For example, such material can be Mn-Zn ferrite.
The closing part 5 is made of magnetic material for which permeability decreases rapidly with the increase in frequency. For example, such material can be a typical transformer Fe-Si plate.

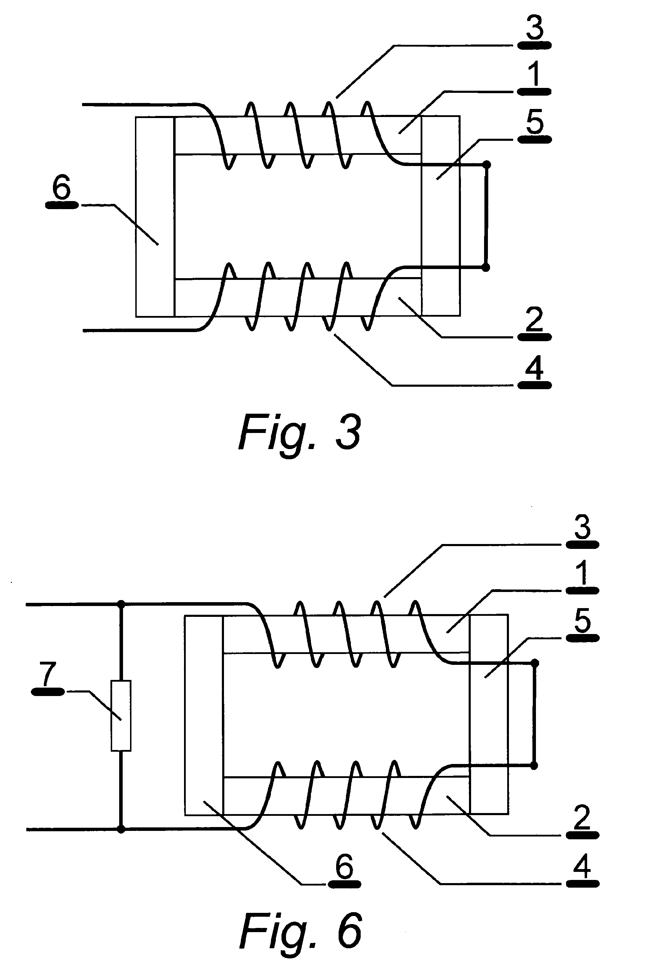

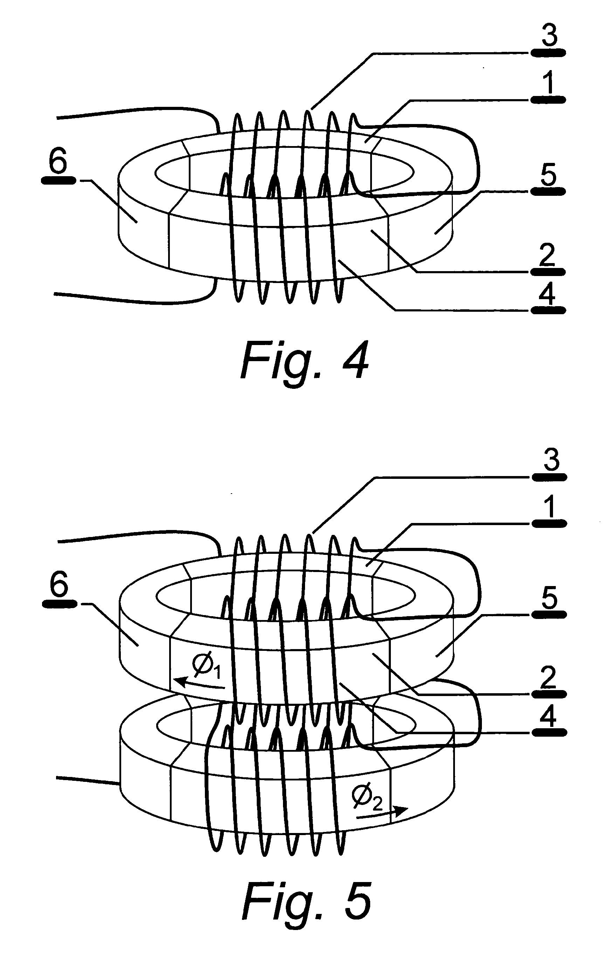

Embodiment III of the invention.
The device for suppressing high frequency current and voltage components is a reactor which contains active parts in the form of two magnetic cores, the first one 1 and the second one 2. On the first magnetic core 1 there is wound winding 3, which is connected in series and anti-parallel with winding 4, which is wound on the second magnetic core 2. Both magnetic cores 1 and 2 are connected with each other by means of a closing parts 5 and 6 in the form of magnetic cores of different magnetic properties than those of the cores 1 and 2. The magnetic circuit shown in fig.3, formed by the cores 1 and 2 and the closing parts 5 and 6, has a rectangular shape, but this shape can be different, for example, as shown in fig. 4 it can have the shape of a circular ring or, which is not shown in the drawing, an oval shape or a shape similar to an oval, or it can be rectangular with rounded corners. In this case the active parts of the core together with the parts that close the magnetic circuit of the core constitute a magnetic circuit which is made of one magnetic material whose characteristic feature is that its magnetic permeability decreases rapidly with increase in frequency. An example of such material is transformer Fe-Si plate. The toroidal core shown in fig. 4 is such a version of the invention embodiment.

Embodiment IV of the invention, shown on fig.5
A single reactor containing active parts in the form of two magnetic cores 1 and 2 and windings 3 and 4 interconnected in series and anti-parallel which are wound on the magnetic cores 1 and 2 is connected with another reactor of an identical design, which are situated one over/under the other in close proximity. In such case the input/output of the first winding 3 of one of the reactors is connected in series and anti-parallel with the output/input 4 of the other reactor. The number of reactors set up together can be more than two in which case the set-up reactors form a stack, which is not shown in the drawing in which individual reactors are connected with one another by windings. A complete reactor stack can be placed in one housing, which is not shown in the drawing.

The inventive device works in the following way.
If low frequency current (50/60Hz) passes through the reactor's windings 3 and 4 connected in series, the magnetic fluxes generated by the windings are closed within the magnetic circuit formed by cores 1 and 2. Due to the anti-parallel way of connecting the windings, these fluxes compensate themselves in the magnetic circuit of the reactor and the resultant flux is near zero. Also the resultant impedance of the reactor is near zero. If the reactor is connected in parallel with a resistor 7, or if additional windings loaded with a resistor are wound, which is not shown in the drawing, the value of the resultant impedance is also near zero. Therefore, voltage drop across the device resulting from passage of low frequency current is near zero.
If high-frequency current passes through reactor windings connected in series, magnetic fluxes generated by the windings 3 and 4 are closed partly in magnetic cores 1 and 2 and partly outside them. Therefore flux compensation in an individual core is limited and the magnetically divided windings together with core fragments constitute induction elements connected in series. For high frequency range the resultant impedance of the reactor is large compared to the resultant impedance for low frequency range. If the reactor is connected with the resistor 7 in parallel, or if additional windings loaded with a resistor have been wound, the resultant impedance of the device is close to the resistance of the resistor. Thus, for high frequency range, a series resistive element is introduced into the line.

The operation of the device presented in fig. 5 consists in mutual coupling of the windings of the neighbouring reactors, which are in close proximity. In this case the resultant impedance of reactors connected in series and arranged in a stack is bigger than the total impedance of individual reactors. The above described increase in resultant impedance is possible if fluxes Φ₁ and Φ₂ generated by the windings of neighbouring reactors being in close proximity have opposite directions.

Due to its small dimensions, the device according to the present invention can be placed inside a high voltage bushing.

## Claims

1. A device for suppressing high frequency current or/and voltage components, in which a series impedance element is used, **characterised in that** the series impedance element is at least one magnetic core reactor whose magnetic circuit comprises at least two active parts on which the reactor windings (3) and (4) connected in series and anti-parallel are wound.

2. A device according to claim 1, **characterised in that** the active parts are separate magnetic cores (1) and (2).

3. A device according to claim 1, **characterised in that** the magnetic cores (1) and (2) are connected with each other by a closing part (5), forming a magnetic core open at one end.

4. A device according to claim 1, **characterised in that** the magnetic cores (1) and (2) are connected with each other by the closing parts (5) and (6), forming a closed magnetic core.

5. A device according to claim 4, **characterised in that** the closed magnetic core has the shape of a circular ring.

6. A device according to claim 4, **characterised in that** the active parts of the core together with the parts that close the magnetic circuit of the core are a toroidal core which is made of one magnetic material whose characteristic feature is that its magnetic permeability decreases rapidly with increase in frequency.

7. A device according to claim 1, **characterised in that** the active parts are made of magnetic material with a broad-band magnetic permeability characteristic.

8. A device according to claim 3 or 4, **characterised in that** the parts that close the magnetic circuit of the core are made of magnetic material for which permeability decreases rapidly with increase in frequency.

9. A device according to claim 1, **characterised in that** it consists of at least two magnetic core reactors connected with each other in series and forming a stack in which the neighbouring windings of the neighbouring reactors are situated in such way that the magnetic fluxes produced by them are directed in opposite directions.

10. A device according to claim 9, **characterised in that** the reactor stack is placed in a common housing.

11. A device according to claims 1-10, **characterised in that** a resistor is connected in parallel to the input and output terminals of the reactor.

12. A device according to claims 1-11, **characterised in that** it is placed inside a high voltage bushing.
